# FASCICULE DE BREVET EUROPEEN

(11) **EP 2 120 258 B1**
(45) Date de publication et mention de la délivrance du brevet: **06.07.2011**
(21) Numéro de dépôt: 09159902.7
(22) Date de dépôt: 11.05.2009
(51) Int. Cl.: H01L 21/336, H01L 29/417, H01L 29/78, H01L 29/786, H01L 29/51

(54) **Procédé de réalisation d'un transistor à source et drain métalliques**
Herstellungsverfahren eines Transistors mit Metallquelle und -abfluss
Method for manufacturing a transistor with metal source and drain

(30) Priorité: 13.05.2008 FR 0853084
(43) Date de publication de la demande: 18.11.2009
(73) Titulaire: Commissariat à l'Énergie Atomique et aux Énergies Alternatives, 75015 Paris (FR)
(72) Inventeur: Vinet, Maud, 38140 Rives (FR); Poiroux, Thierry, 38340 Voreppe (FR); Previtali, Bernard, 38100 Grenoble (FR)
(74) Mandataire: Ilgart, Jean-Christophe

(56) Documents cités:
- WO-A-01/71818
- WO-A-2007/060641
- US-A1- 2003 045 039
- US-A1- 2006 038 229

## Description

### DOMAINE TECHNIQUE

L'invention concerne un procédé de réalisation d'un transistor à effet de champ, par exemple un transistor MOS (Métal Oxyde Semi-conducteur), comportant une source et un drain métalliques ou à base d'au moins un métal et d'un alliage métal/semi-conducteur. L'invention s'applique également pour la réalisation de transistors à double grille.

### ÉTAT DE LA TECHNIQUE ANTÉRIEURE

Pour réaliser un transistor MOS à source et drain métalliques, il est connu de réaliser tout d'abord un transistor MOS classique comprenant une source, un canal et un drain formés dans une couche active d'un substrat SOI (semi-conducteur sur isolant), une grille et des espaceurs formés autour de la grille. Une couche métallique est ensuite déposée sur toute la surface du wafer (ou substrat), recouvrant ainsi entièrement le transistor. On réalise ensuite un recuit formant des portions d'alliage métal/semi-conducteur, appelé siliciure lorsque le semi-conducteur est du silicium, au niveau des zones comportant un contact direct entre le semi-conducteur de la couche active et le métal déposé.

Un tel procédé nécessite toutefois la mise en oeuvre, après la réalisation des zones de siliciure, d'un retrait sélectif du métal n'ayant pas réagi avec le semi-conducteur afin d'éviter des courts-circuits au niveau du transistor (par exemple entre le drain et la source) et avec d'autres transistors présents sur le substrat. Par exemple, si le métal utilisé est du cobalt, le retrait sélectif est réalisé à partir d'une solution chimique à base de NH₄OH / H₂O₂ / H₂O-La nécessité de réaliser ce retrait sélectif restreint le choix des métaux pouvant être utilisés pour former l'alliage métal/semi-conducteur car ce métal doit présenter des propriétés lui permettant d'être retiré sélectivement par rapport aux autres matériaux du transistor.

De plus, la pénétration du siliciure dans la couche active est très sensible à la dispersion sur l'épaisseur initiale de la couche active de silicium, ces dispersions se retrouvant ensuite dans les portions de siliciure réalisées et induisant de fortes dispersions sur les caractéristiques des transistors ainsi réalisés.

Dans le document WO 01/95383, une siliciuration au niveau de la source et du drain du transistor est réalisée à partir d'une première couche métallique déposée sur le transistor, puis une seconde couche métallique est déposée sur toute la surface du wafer pour permettre de reprendre ultérieurement les contacts électriques de la source et du drain. A ce stade du procédé, tous les transistors présents sur le wafer sont en court-circuit interne (contact entre la source et le drain par l'intermédiaire des couches métalliques passant au-dessus de la grille et sur la source et le drain) et en court-circuit les uns avec les autres. Afin de supprimer le court-circuit interne, une planarisation mécano-chimique (CMP) est réalisée avec arrêt sur un masque dur présent sur la grille du transistor, permettant de supprimer les portions des couches métalliques reliant électriquement la source et le drain. Le court-circuit entre les transistors est supprimé en réalisant une gravure de portions des couches métalliques se trouvant en dehors de la région active.

Étant donné qu'une gravure des couches métalliques (permettant de supprimer le court-circuit entre les transistors) est mise en oeuvre après l'étape de CMP, il existe alors une contrainte sur la nature des métaux de ces couches métalliques car il est nécessaire de pouvoir les graver sélectivement par rapport aux autres matériaux présents, par exemple le masque dur présent sur la grille qui est à base de SiO₂ ou de Si₃N₄, ou encore le matériau de la grille. Il n'est par exemple pas possible d'utiliser du tungstène pour réaliser la seconde couche métallique, qui est pourtant un matériau bien adapté pour réaliser cette seconde couche métallique du fait de sa faible résistivité et de sa bonne compatibilité avec le silicium, car celui-ci se grave de manière chimique à partir d'une solution chlorée ou fluorée qui grave également les oxydes. Une telle gravure pourrait donc endommager les espaceurs de grille non protégés lors de cette gravure.

Si la gravure des couches métalliques est mise en oeuvre avant l'étape de CMP, l'épaisseur de la seconde couche métallique n'est alors pas constante sur tout le wafer. Elle est notamment plus importante aux passages de marche, c'est-à-dire en périphérie des grilles, ce qui peut impliquer, après la réalisation de l'étape de gravure, la formation d'espaceurs métalliques autour de certaines grilles pouvant maintenir le court-circuit source/drain existant.

Le document WO 01/71818 A1 décrit un procédé de réalisation d'un transistor MOS au cours duquel une siliciuration des parois latérales du canal du transistor est mise en oeuvre à partir d'une première couche métallique déposée sur le transistor. Une seconde couche métallique est ensuite déposée sur toute la surface du wafer pour réaliser la source et le drain du transistor.

Là encore, ce procédé implique nécessairement de supprimer le court-circuit entre les transistors par une gravure de portions des couches métalliques se trouvant en dehors de la région active, posant les mêmes problèmes que ceux exposés précédemment pour le document WO 01/95383

US 2006/038229 A1 (TSUCHIYA YOSHINORI [JP] ET AL) 23 février 2006 (2006-02-23) décrit, voir figures 13-16 et le texte correspondant, la réalisation d'un MOSFET. Partant d'un empilement de porte comprenant un masque dur en SiN 4, une couche isolante est déposée sur toute la surface et ensuite enlevée par lithographie et gravure RIE au niveau des sources et drains. Ensuite, un métal permettant de former un siliciure est déposé (Er pour n-MOS et Pt pour p-MOS). L'ensemble est recouvert de Cu. Une siliciuration a lieu. Ensuite, une planarisation CMP a lieu. Il est implicite que le masque dur 4 sert de couche d'arrêt.

### EXPOSÉ DE L'INVENTION

Un but de la présente invention est de proposer un procédé de réalisation d'un transistor à source et drain métallique peu coûteux, comportant un nombre d'étapes réduit et ne nécessitant pas la mise en oeuvre d'une gravure sélective de métal après la réalisation de portions d'alliage métal/semi-conducteur en contact avec le canal.

Pour cela, la présente invention propose un procédé de réalisation d'un transistor à effet de champ, comportant au moins les étapes de :
a) réalisation, sur un substrat, d'une structure comprenant une portion de matériau semi-conducteur formant un canal du transistor, une grille disposée sur le canal et un masque dur disposé sur la grille,
b) formation d'au moins une portion diélectrique recouvrant complètement ladite structure et des zones du substrat correspondant à des emplacements d'une source et d'un drain du transistor et une zone périphérique auxdits emplacements, et comprenant une face, opposée à une face en contact avec le substrat, sensiblement plane,
c) réalisation, dans la portion diélectrique, de deux trous de part et d'autre de ladite structure, tels que les emplacements de la source et du drain forment les parois de fond des trous et que des flancs latéraux de la portion de matériau semi-conducteur soient mis à nu,
d) dépôt d'une première couche métallique au moins sur les parois des trous, recouvrant au moins lesdits flancs latéraux du canal,
e) siliciuration desdits flancs latéraux du canal,
f) dépôt d'une seconde couche métallique sur la première couche métallique, formant, avec les portions précédemment siliciurées, la source et le drain du transistor,
g) planarisation mécano-chimique de la seconde couche métallique avec arrêt sur le masque dur.

La source et le drain du transistor obtenu par la mise en oeuvre de ce procédé de réalisation comporte des portions à base d'un alliage entre le matériau utilisé pour réaliser le canal, par exemple du silicium, du germanium ou un alliage silicium-germanium, et un métal. Un tel alliage est appelé siliciure lorsque celui-ci correspond à un alliage entre du silicium et un métal, germaniure lorsque celui-ci correspond à un alliage entre du germanium et un métal, et silico-germaniure lorsque celui-ci correspond à un alliage entre du silicium-germanium et un métal. Dans la suite du document, le terme « siliciure » sera utilisé pour désigner tout alliage d'un semi-conducteur et d'un métal.

Une telle structure de transistor a notamment pour avantage de diminuer la résistance d'accès à la source et au drain du transistor car le procédé n'impose aucune restriction quant au choix du ou des métaux utilisés pour former les portions de siliciure et la source et le drain du transistor. Ceci est particulièrement avantageux lorsque le métal qui n'a pas réagi avec le semi-conducteur pour former le siliciure est très peu résistif par rapport au métal utilisé pour former le reste de la source et le drain du transistor.

Lorsque le canal est à base de semi-conducteur dopé P, la première couche métallique peut être de préférence à base de platine et/ou d'iridium. Lorsque le canal est à base de semi-conducteur dopé N, la première couche métallique peut être de préférence à base d'erbium et/ou d'ytterbium ou encore le nickel. De manière générale, la première couche métallique peut être à base de platine et/ou de nickel et/ou d'erbium et/ou d'ytterbium et/ou de cobalt et/ou de titane et/ou d'iridium.

L'utilisation de tels métaux présente des avantages par rapport à un bi-couche composé de tungstène et de TiN utilisé dans les procédés de l'art antérieur. En effet, le TiN, qui est en contact avec le siliciure, forme une couche barrière vis-à-vis du tungstène et est très résistif (résistivité électrique p égale à environ 2000.10⁻⁹ Ω.m) par rapport à d'autres métaux, par exemple du platine (p = 94.10⁻⁹ Ω.m) ou du nickel (p = 70.10⁻⁹ Ω.m) . Il est ainsi possible d'augmenter le courant délivré par le transistor.

Ce procédé de fabrication du transistor permet de réaliser un transistor à source et drain métalliques avec n'importe quel métal, en particulier avec les métaux ne pouvant pas être gravés et/ou les siliciures ne pouvant pas être retirés sélectivement par rapport au métal résiduel n'ayant pas réagi avec le semi-conducteur pour former le siliciure.

L'invention s'applique aussi bien pour des transistors simple grille que pour des transistors double grille. L'invention s'applique également pour la réalisation de transistors Hautes Performances (HP).

Enfin, ce procédé est compatible avec la réalisation, sur un même substrat, de transistors comprenant des matériaux de canal différents (par exemple Si et Ge) sans dépendre d'une chimie de retrait sélectif de la première couche métallique commune aux transistors.

La portion de matériau semi-conducteur peut être une portion d'une couche superficielle semi-conductrice du substrat de type SOI et les emplacements de la source et du drain peuvent être des zones d'une couche diélectrique du substrat SOI mises à nu par gravure de la couche superficielle semi-conductrice.

La formation de la portion diélectrique à l'étape b) peut être obtenue par la mise en oeuvre des étapes suivantes :
- dépôt d'une première couche diélectrique recouvrant complètement ladite structure et les emplacements de la source et du drain du transistor et la zone périphérique,
- dépôt d'une seconde couche diélectrique sur la première couche diélectrique,
- planarisation mécano-chimique de la seconde couche diélectrique avec arrêt sur la première couche diélectrique.

La réalisation des deux trous à l'étape c) peut être obtenue par lithographie et gravure de portions de la seconde couche diélectrique se trouvant au niveau, ou au-dessus, des emplacements de la source et du drain, et ensuite d'un retrait de portions de la première couche diélectrique non recouvertes par des portions restantes de la seconde couche diélectrique.

La réalisation des deux trous à l'étape c) peut être obtenue par lithographie et gravure des zones de la portion diélectrique recouvrant les emplacements de la source et du drain.

A l'étape d), le dépôt de la première couche métallique peut également être réalisé sur la structure et sur la portion diélectrique, au niveau de la zone périphérique.

Le procédé peut comporter en outre, entre les étapes e) et f), une étape de dépôt d'une couche à base de titane et/ou de nitrure de titane et/ou de tungstène, sur la première couche métallique.

Le procédé peut comporter en outre, après l'étape f), une étape de dépôt d'une couche d'oxyde sur la seconde couche métallique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1I représentent les étapes d'un procédé de réalisation d'un transistor à source et drain métalliques, objet de la présente invention, selon un mode de réalisation particulier,
- les figures 2A à 2D représentent des étapes d'un procédé de réalisation d'un transistor double grille à source et drain métalliques, également objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

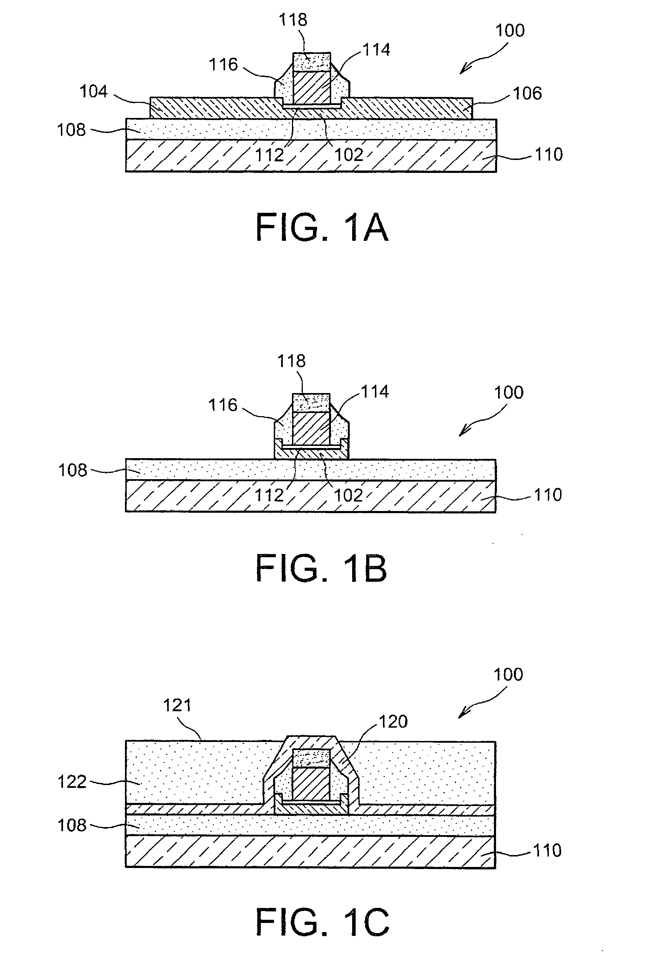

On se réfère aux figures 1A à 1I qui représentent les étapes d'un procédé de réalisation d'un transistor MOS 100 à source et drain métalliques selon un mode de réalisation particulier.

Dans ce mode de réalisation, le transistor 100 est réalisé à partir d'un substrat SOI. Dans une variante, le transistor 100 pourrait être réalisé à partir d'un substrat massif à base de semi-conducteur, par exemple à base de silicium, ou à partir d'un substrat de type germanium sur isolant ou un composé à base de silicium et de germanium sur isolant.

Comme représenté sur la figure 1A, on met tout d'abord en oeuvre des étapes de réalisation standards d'un transistor MOS à partir d'un substrat SOI. On définit notamment dans une couche active, pouvant être mince et de préférence à base de silicium et/ou de germanium, d'un substrat SOI, un canal 102 et des portions 104 et 106 correspondant aux emplacements respectifs de la source et du drain du transistor 100. Cette couche active est disposée au dessus d'une couche diélectrique 108, par exemple à base de SiO₂, et d'une couche massive 110 à base d'un semi-conducteur tel que du silicium.

Le transistor 100 comporte également un diélectrique de grille 112, pouvant être à base d'un matériau diélectrique à forte permittivité (« High-K », c'est-à-dire de constante diélectrique supérieure ou égale à 4) tel que du HfO₂, une grille 114, par exemple à base de polysilicium dopé et/ou de métal, et des espaceurs 116 formés sur les flancs de la grille 114. Ces espaceurs 116 peuvent par exemple comporter une première couche de SiO₂ et une seconde couche de SiN.

Le transistor 100 comporte également un masque dur 118 formé au-dessus de la grille 114. Ce masque dur 118 peut être à base d'un oxyde ou d'un nitrure de semi-conducteur, ou encore formé par un bi-couche d'oxyde et de nitrure de semi-conducteur, par exemple un bi-couche SiO₂/Si₃N₄. Le rôle de ce masque dur 118 sera détaillé plus loin.

Les zones actives et la grille du transistor 100 peuvent être réalisées par lithographie et gravure. Après définition de la grille, des implantations LDD (« Light Doped Drain ») et LDS (« Light Doped Source ») (non représentées) peuvent être réalisées pour former des zones d'extensions sous la grille 114, éventuellement précédées de la fabrication d'un espaceur et d'une épitaxie sélective destinée à augmenter l'épaisseur du silicium qui ne se trouve pas sous la grille 114. Ces implantations peuvent ensuite être activées thermiquement par recuit.

Comme représenté sur la figure 1B, on réalise ensuite une gravure, sélectivement par rapport aux espaceurs 116 et au masque dur 118, des portions 104 et 106 de la couche active. Lorsque la couche active est à base de silicium, cette gravure peut par exemple être réalisée grâce à une gravure plasma à partir de HBr et sous atmosphère d'He/O₂ à forte pression (65 mTorr par exemple). On obtient sur le substrat une structure formée par le canal 102, le diélectrique de grille 112, la grille 114, les espaceurs 116 et le masque dur 118.

Ensuite, on dépose une couche 120, par exemple à base de nitrure de semi-conducteur tel que du SiN, déposée de manière conforme sur la structure précédemment décrite et sur la couche diélectrique 108. Cette couche 120 peut être déposée par exemple par CVD (dépôt chimique en phase vapeur).

Après le dépôt de la couche 120, on dépose une couche diélectrique 122, par exemple à base de SiO₂, et pouvant être obtenue par un dépôt de type HDP (plasma de haute densité) à partir d'un composé chimique de type silane (figure 1C). Le matériau de la couche diélectrique 122 est choisi de préférence tel qu'il puisse être facilement planarisé. On réalise alors une CMP de cette couche 122 avec arrêt sur la couche 120 (sur la portion de la couche 120 se trouvant au-dessus du masque dur 118). On obtient ainsi une portion diélectrique recouvrant tous les éléments réalisés sur le substrat et présentant une face 121, opposée à une face se trouvant du côté de la couche diélectrique 108, sensiblement plane.

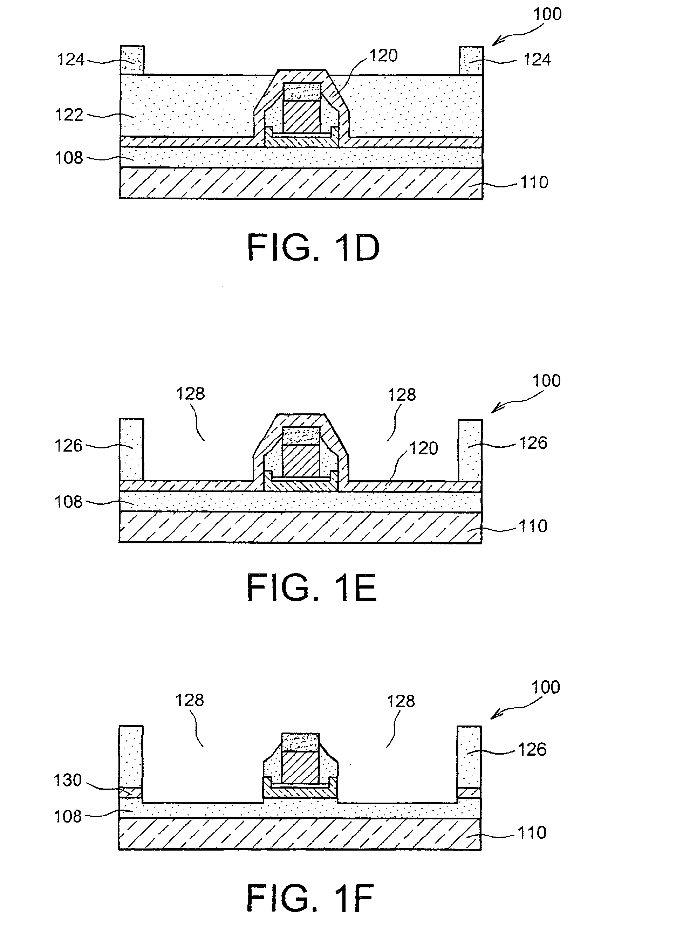

La couche 120 sera également utilisée dans la suite du procédé en tant que couche d'arrêt lors d'une gravure ultérieure (qui sera décrite en liaison avec la figure 1E). Le choix de l'épaisseur de la couche 120 dépend donc de la sélectivité de la gravure qui sera réalisée ultérieurement et pour laquelle la couche 120 sera utilisée en tant que couche d'arrêt, ainsi que de la sélectivité de la CMP de la couche 122 précédemment réalisée. La couche d'arrêt 120 peut par exemple avoir une épaisseur comprise entre environ 10 nm et 50 nm, et par exemple égale à environ 50 nm.

Comme représenté sur la figure 1D, on dépose un masque 124, par exemple à base de résine, délimitant les emplacements de la source et du drain du transistor 100 qui seront réalisés dans la suite du procédé sur la couche diélectrique 108. On réalise ensuite une insolation par faisceau d'électrons ou photolithographie de la couche diélectrique 122 au niveau des zones non recouvertes par le masque 124.

On réalise ensuite une gravure de la couche diélectrique 122 avec arrêt sur la couche 120 (figure 1E). Les portions de la couche 122 se trouvant au niveau des emplacements sur lesquels la source et le drain du transistor 100 sont destinés à être réalisés (et correspondant aux emplacements des anciennes portions 104 et 106 représentées sur la figure 1A) sont donc supprimées, formant des trous 128 au-dessus de ces emplacements, entre des portions restantes 126 de la couche diélectrique 122 disposées au niveau d'une zone périphérique correspondant aux zones d'isolation du transistor 100. Cette gravure peut par exemple être une gravure plasma ou une combinaison d'une gravure plasma et d'une gravure chimique humide, par exemple avec une solution du type BOE80:1. Le masque de résine 124 est ensuite retiré.

Comme représenté sur la figure 1F, les portions de la couche d'arrêt 120 se trouvant sur la structure (canal + grille + diélectrique de grille + masque dur + espaceurs) précédemment réalisée sur le substrat et au fond des trous 128 sont ensuite supprimées, par exemple par une gravure combinant un plasma O₂ et une solution chimique de type SC1 (« standard clean 1 », c'est-à-dire un mélange d'ammoniaque, d'eau oxygénée et d'eau). Des portions restantes 130 de la couche d'arrêt 120, se trouvant sous les portions restantes 126 de la couche 122, au niveau des zones d'isolation du transistor, sont conservées. On obtient ainsi des trous 128 comportant des parois de fond formées par les emplacements de la source et du drain du transistor 100. De plus, en supprimant la couche 120, on met à nu les flancs latéraux du canal 102 destinés à être en contact avec la source et le drain du transistor 100.

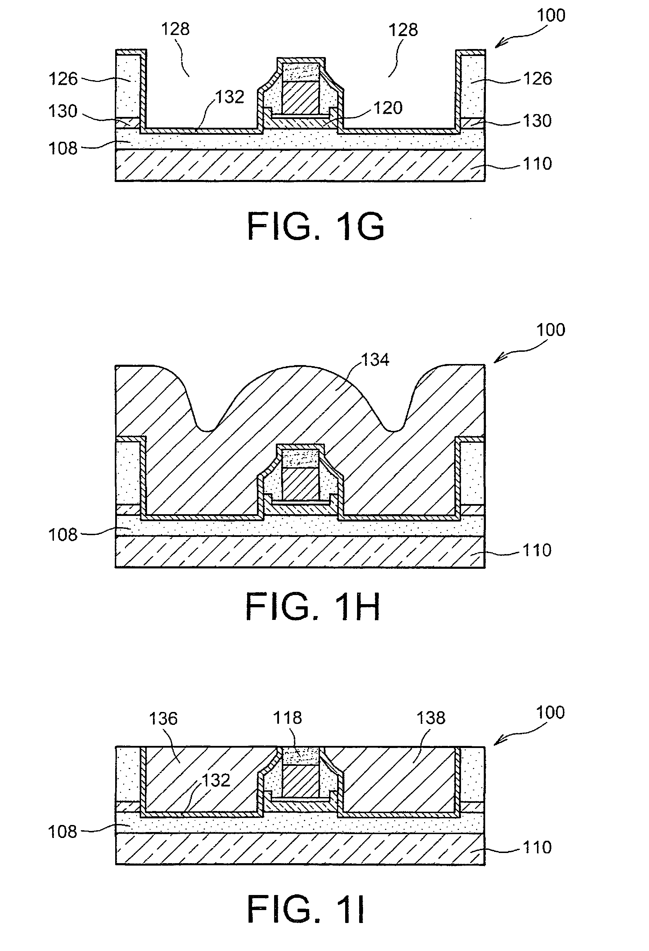

On dépose ensuite de manière conforme sur l'ensemble du transistor 100, et notamment sur les parois des trous 128, sur les portions diélectriques restantes 126, sur la structure précédemment formée sur le substrat et sur les flancs du canal 102 précédemment mis à nu, une première couche métallique 132 (figure 1G) . Le métal de cette couche 132 est destiné à former un alliage avec le semi-conducteur du canal 102. Cette première couche métallique 132 peut notamment être à base de :
- iridium et/ou platine dans le cas d'un transistor 100 de type PMOS à canal 102 de silicium,
- nickel et/ou erbium et/ou ytterbium dans le cas d'un transistor 100 de type NMOS à canal 102 de silicium ;
- platine dans le cas d'un transistor 100 de type PMOS à canal 102 de silicium-germanium.

Le choix du métal utilisé pour former cet alliage repose sur plusieurs critères : hauteur de barrière entre le métal de la couche 132 et le semi-conducteur du canal 102, aptitude à ségréger les dopants, intégrabilité (c'est-à-dire sa faculté à être mis en oeuvre dans un procédé de fabrication de transistor), etc. Le métal de la couche 132 est apte à former, avec le semi-conducteur du canal 102, un siliciure et peut être gravé sélectivement ou non par rapport aux autres matériaux du transistor 100.

L'épaisseur de la première couche de métal 132 est choisie pour permettre de siliciurer les flancs du canal 102 précédemment mis à nu sur une distance désirée, sous les espaceurs 116. Par exemple, une couche 132 à base de platine pourra être déposée par PVD (dépôt physique en phase vapeur), et avoir une épaisseur égale à environ 9 nm. Une telle couche 132 permettra d'obtenir une épaisseur de platine égale à environ 4 nm au niveau des flancs latéraux du canal 102 et permettra d'obtenir un siliciure pénétrant sous les espaceurs 116 sur une distance égale à environ 15 nm lorsque le canal 102 a une épaisseur égale à environ 10 nm. Lorsque la couche 132 est à base de nickel, elle pourra avoir également une épaisseur égale à environ 9 nm.

On effectue ensuite un recuit de siliciuration permettant de former l'alliage désiré au niveau du canal 102 (par exemple, recuit à une température égale à environ 450°C, sous atmosphère d'azote dans le cas d'une couche 132 à base de platine).

De plus, lorsque le transistor 100 comporte des zones d'extensions (LDD / LDS) au voisinage du canal 102, la première couche de métal 132 forme alors des contacts électriques à base de siliciure avec ces zones d'extension.

On dépose ensuite, sur la première couche métallique 132, une seconde couche métallique 134 pour remplir les trous 128. Cette seconde couche métallique 134 est ici déposée sur l'ensemble du transistor 100. La nature du métal de cette couche 134 est choisie en fonction de son aptitude à remplir les trous 128 et de sa faible résistivité, cette couche étant destinée à former la source et le drain du transistor 100. Avantageusement, cette seconde couche métallique 134 peut être à base de tungstène, déposée par CVD à partir de précurseur WF₆, et éventuellement précédée du dépôt d'une couche de Ti/TiN ou TiN servant de barrière de diffusion au fluor (non représentée) et/ou suivi d'un dépôt d'une couche tampon (« capping layer ») à base d'oxyde (non représentée) sur la seconde couche métallique 134 afin de favoriser la CMP réalisée par la suite.

Sur la figure 1I, on effectue une CMP de la première couche de métal 132, de la seconde couche de métal 134 et des éventuelles autres couches déposées au cours de l'étape décrite précédemment en relation avec la figure 1H, avec arrêt sur le masque dur 118. On obtient ainsi des portions métalliques 136 et 138, formant respectivement, avec les portions restantes de la première couche métallique 132, la source et le drain du transistor 100. Lorsqu'une couche tampon à base d'oxyde est déposée sur la seconde couche métallique 134 avant la CMP, cette couche tampon permet de limiter les phénomènes parasites de creusement des zones basses dans la seconde couche métallique 134 et d'érosion de zones hautes de cette couche 134.

Ce procédé s'applique particulièrement pour la réalisation de transistors CMOS. On réalise par exemple un ou plusieurs premiers transistors NMOS comportant un premier type de siliciure réalisé au niveau des jonctions canal - source et canal - drain, et un ou plusieurs seconds transistors PMOS comportant un autre type de siliciure au niveau de ses jonctions. Pour cela, il suffit de graver successivement les trous 128 correspondant à chaque type de transistor. Par exemple, on commence par une gravure des trous 128 pour les transistors PMOS et un dépôt du métal adapté (par exemple iridium et/ou platine) pour former la première couche de métal 132 de ces transistors. Puis, grâce à une seconde lithographie et gravure, on réalise les trous 128 pour les transistors NMOS et on dépose ensuite un métal adapté (par exemple du nickel) pour former la première couche de métal 132 de ces transistors. On effectue ensuite un recuit de siliciuration et on dépose finalement un métal pour remplir les trous 128 de tous les transistors (seconde couche métallique 134 commune aux transistors PMOS et NMOS) et on réalise une CMP permettant d'isoler électriquement les transistors les uns des autres et d'isoler électriquement la source et le drain de chaque transistor.

Ce procédé de réalisation de transistor à source et drain métalliques est applicable à toutes les architectures de transistor à effet de champ, et notamment des transistors double grille, dès qu'il est possible de graver l'épaisseur de semi-conducteur au niveau des zones de source et du drain du transistor.

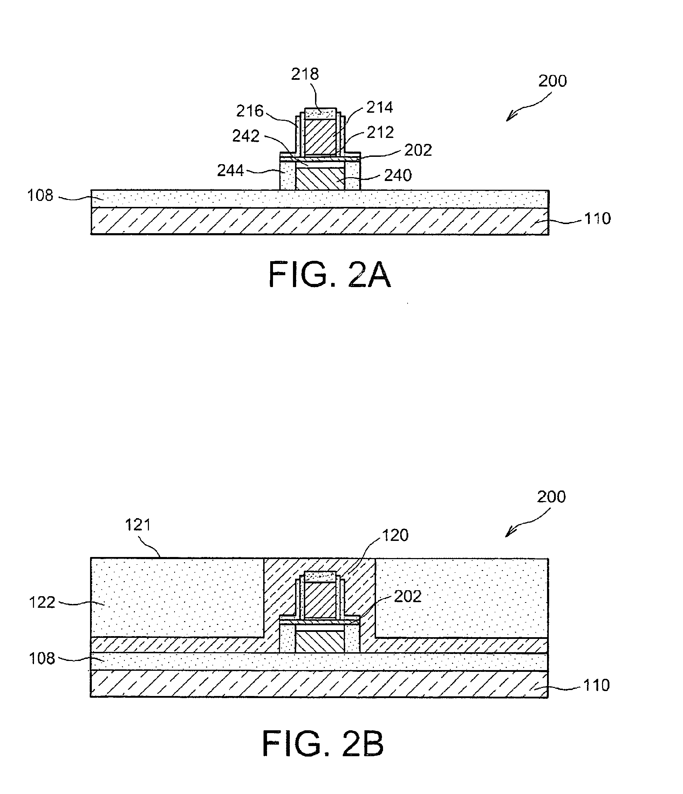

Pour la réalisation d'un transistor double grille, on se réfère aux figures 2A à 2D qui représentent des étapes d'un procédé de réalisation d'un transistor 200 double grille à source et drain métalliques selon un mode de réalisation particulier.

Dans ce mode de réalisation, le transistor 200 est réalisé à partir d' un substrat SOI. Toutefois, comme pour le transistor 100 décrit précédemment, le transistor 200 pourrait être réalisé à partir d'un substrat massif à base de semi-conducteur, par exemple à base de silicium, ou à partir d'un substrat de type germanium sur isolant ou un alliage à base de silicium et de germanium sur isolant.

Sur la figure 2A, on met tout d'abord en oeuvre des étapes de réalisation standards d'un transistor MOS double grille à partir d'un substrat SOI, par exemple par collage et gravure de couches, afin de former sur la couche diélectrique 108 une structure comportant un canal 202, deux diélectriques de grilles 212 et 242, deux grilles 214 et 240, des espaceurs 216 formés sur les flancs de la grille 214, des espaceurs 244 formés sur les flancs de la grille 240, et un masque dur 218 formé au-dessus de la grille 214.

Par rapport au transistor 100 précédemment décrit, on voit donc que le transistor 200 comporte une grille arrière 240 supplémentaire, ainsi qu'un diélectrique de grille 242 et des espaceurs 244 associés à cette grille arrière 240.

Comme pour la réalisation du transistor 100, on dépose ensuite la couche 120 de manière conforme sur la structure précédemment décrite et sur la couche diélectrique 108. Après le dépôt de la couche 120, on dépose la couche diélectrique 122 (figure 2B). On réalise alors une CMP de cette couche 122 avec arrêt sur la couche 120 (sur la portion de la couche 120 se trouvant au-dessus du masque dur 218), formant ainsi une portion diélectrique recouvrant tous les éléments réalisés sur le substrat et présentant une face 121, opposée à une face se trouvant du côté de la couche diélectrique 108, sensiblement plane.

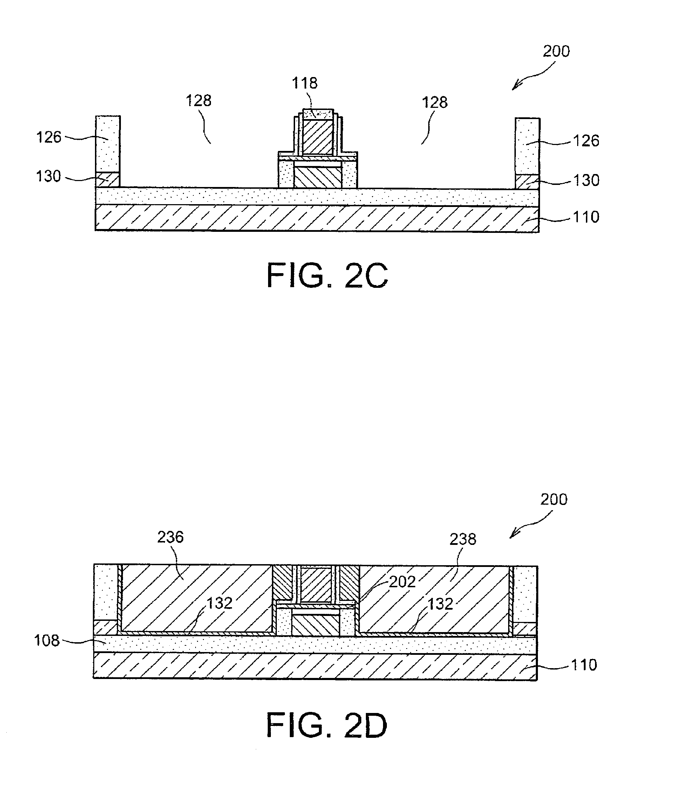

Ensuite, de manière similaire au premier mode de réalisation, on forme des trous 128 à travers les couches diélectriques 120, 122 au niveau des emplacements de la source et du drain du transistor 200 qui seront réalisés dans la suite du procédé sur la couche diélectrique 108. Sur la figure 2C, des portions restantes 126 de la couche diélectrique 122 et des portions restantes 130 de la couche 120 sont disposées au niveau d'une zone périphérique correspondant aux zones d'isolation du transistor 200.

On obtient ainsi des trous 128 comportant des parois de fond formées par les emplacements de la source et du drain du transistor 200. De plus, en supprimant la couche 120, on met à nu les flancs latéraux du canal 202 destinés à être en contact avec la source et le drain du transistor 200.

Sur la figure 2D, on achève le transistor 200 en formant la couche métallique 132, des portions métalliques 236, 238 formant respectivement, avec les portions restantes de la couche métallique 132, la source et le drain du transistor 200, de manière analogue au transistor 100. Un recuit de siliciuration permet de former l'alliage désiré au niveau du canal 202, au niveau des contacts avec la source et le drain du transistor 200.

Ce procédé de réalisation s'applique également à la réalisation de source et drain métalliques pour des transistors sur substrat de semi-conducteur massif, après implantation des LDD, LDS et la réalisation des espaceurs. Pour cela, les étapes du procédé de réalisation sont similaires à celles pour la réalisation des transistors 100 et 200 sur substrat SOI, excepté pour l'étape de gravure de semi-conducteur (au niveau de la source et du drain) formant le canal, avec arrêt sur l'oxyde enterré 108, qui est remplacée par une gravure du substrat sur une épaisseur équivalente à la profondeur des jonctions LDD et LDS.

## Revendications

1. Procédé de réalisation d'un transistor (100) à effet de champ, comportant au moins les étapes de :
a) réalisation, sur un substrat (108, 110), d'une structure comprenant au moins une portion de matériau semi-conducteur formant un canal (102) du transistor, une grille (114) disposée sur le canal et un masque dur (118) disposé sur la grille,
b) formation d'au moins une portion diélectrique recouvrant complètement ladite structure et des zones du substrat correspondant à des emplacements d'une source (136) et d'un drain (138) du transistor et une zone périphérique auxdits emplacements, et comprenant une face (121), opposée à une face en contact avec le substrat, sensiblement plane, par la mise en oeuvre des étapes suivantes :
- dépôt d'une première couche diélectrique (120) recouvrant complètement ladite structure et les emplacements de la source (136) et du drain (138) du transistor (100) et la zone périphérique,
- dépôt d'une seconde couche diélectrique (122) sur la première couche diélectrique (120),
- planarisation mécano-chimique de la seconde couche diélectrique (122) avec arrêt sur la première couche diélectrique (120),
c) réalisation, dans la portion diélectrique, de deux trous (128) de part et d'autre de ladite structure, tels que les emplacements de la source et du drain forment les parois de fond des trous et que des flancs latéraux du canal soient mis à nu,
d) dépôt d'une première couche métallique (132) au moins sur les parois des trous, recouvrant au moins lesdits flancs latéraux du canal,
e) siliciuration desdits flancs latéraux du canal,
f) dépôt d'une seconde couche métallique (134) sur la première couche métallique, formant, avec les portions précédemment siliciurées, la source et le drain du transistor,
g) planarisation mécano-chimique de la seconde couche métallique avec arrêt sur le masque dur.

2. Procédé selon la revendication 1, la portion de matériau semi-conducteur formant le canal (102) étant une portion d'une couche superficielle semi-conductrice du substrat (108, 110) de type SOI et les emplacements de la source (136) et du drain (138) étant des zones d'une couche diélectrique (108) du substrat (108, 110) mises à nu par gravure de la couche superficielle semi-conductrice.

3. Procédé selon l'une des revendications précédentes, la réalisation des deux trous (128) à l'étape c) étant obtenue par lithographie et gravure de portions de la seconde couche diélectrique (122) se trouvant au niveau des emplacements de la source et du drain, et d'un retrait de portions de la première couche diélectrique (120) non recouvertes par des portions restantes (126) de la seconde couche diélectrique (122).

4. Procédé selon l'une des revendications précédentes, dans lequel, à l'étape d), le dépôt de la première couche métallique (132) est également réalisé sur la structure et sur la portion diélectrique restante au niveau de la zone périphérique.

5. Procédé selon l'une des revendications précédentes, comportant en outre, entre les étapes e) et f), une étape de dépôt d'une couche à base de titane et/ou de nitrure de titane et/ou de tungstène, sur la première couche métallique (132).

6. Procédé selon l'une des revendications précédentes, comportant en outre, après l'étape f), une étape de dépôt d'une couche d'oxyde sur la seconde couche métallique (134).

7. Procédé selon l'une des revendications précédentes, la première couche métallique (132) étant à base de platine et/ou de nickel et/ou d'erbium et/ou d'ytterbium et/ou de cobalt et/ou de titane.

## Claims

1. Method for making a field effect transistor (100) comprising at least the following steps:
a) making a structure on a substrate (108, 110), comprising at least a portion of a semiconductor material forming a channel (102) of the transistor, a gate (114) located on the channel and a hard mask (118) located on the gate,
b) formation of at least one dielectric portion completely covering said structure and zones of the substrate corresponding to locations of a source (136) and a drain (138) of the transistor and a peripheral zone at said locations, and comprising an approximately plane face (121) opposite a face in contact with the substrate, using the following steps:
- deposit of a first dielectric layer (120) fully covering said structure and locations of the source (136) and the drain (138) of transistor (100) and the peripheral zone,
- deposit of a second dielectric layer (122) on the first dielectric layer (120),
- chemical mechanical polishing of the second dielectric layer (122) with a stop on the first dielectric layer (120),
c) in the dielectric portion, making two holes (128) on each side of said structure, such that the locations of the source and the drain form the bottom walls of the holes and the sides of the channel are exposed,
d) deposit a first metallic layer (132) on at least the walls of the holes, at least covering said sidewalls of the channel,
e) silicide said sidewalls of the channel,
f) deposit a second metallic layer (134) on the first metallic layer, forming the source and the drain of the transistor in conjunction with the previously silicided portions,
g) chemical mechanical polishing of the second metallic layer with a stop on the hard mask.

2. Method according to claim 1, the portion of semiconductor material forming the channel (102) being a portion of a semiconductor surface layer of the SOI type substrate (108, 110) and the source (136) and drain (138) locations being zones of a dielectric layer (108) of the substrate (108, 110) exposed by etching of the semiconductor surface layer.

3. Method according to one of preceding claims, the two holes (128) made in step c) being obtained by lithography and etching of portions of the second dielectric layer (122) that are at the locations of the source and drain, and a withdrawal of portions of the first dielectric layer (120) not covered by portions (126) remaining from the second dielectric layer (122).

4. Method according to one of preceding claims, in which in step d), the first metallic layer (132) is also deposited on the structure and on the dielectric portion remaining at the peripheral zone.

5. Method according to one of preceding claims, also including a step to deposit a layer composed of titanium and/or titanium nitride and/or tungsten on the first metallic layer (132), between steps e) and f).

6. Method according to one of preceding claims, also including a step to deposit an oxide layer on the second metallic layer (134) after step f).

7. Method according to one of the previous claims, the first metallic layer (132) being composed of platinum and/or nickel and/or erbium and/or ytterbium and/or cobalt and/or titanium.

## Patentansprüche

1. Verfahren zur Herstellung eines Feldeffekttransistors (100), das mindestens die folgenden Schritte umfaßt:
a) Herstellen einer Struktur, die mindestens einen einen Kanal (102) des Transistors bildenden Halbleitermaterialbereich, ein auf dem Kanal angeordnetes Gate (114) und eine auf dem Gate angeordnete harte Maske (118) aufweist, auf einem Substrat (108, 110),
b) Ausbilden von mindestens einem dielektrischen Bereich, der die Struktur und Zonen des Substrats, die den Orten einer Source (136) und eines Drain (138) des Transistors entsprechen, und eine zu diesen Orten periphere Zone vollständig bedeckt und eine zu einer mit dem Substrat in Kontakt stehenden Fläche entgegengesetzte Fläche (121) umfaßt, die im wesentlichen plan ist, durch Durchführen der folgenden Schritte:
- Aufbringen einer ersten dielektrischen Schicht (120), die die Struktur und die Orte der Source (136; und des Drain (138) des Transistors (100) und die periphere Zone vollständig bedeckt,
- Aufbringen einer zweiten dielektrischen Schicht (122) auf die erste dielektrische Schicht (120),
- mechanisch/chemisches Einebnen der zweiten dielektrischen Schicht (122) unter Stoppen an der ersten dielektrischen Schicht (120),
c) Herstellen von zwei Löchern (128) auf den beiden Seiten der Struktur in dem dielektrischen Bereich derart, daß die Orte der Source und des Drain die Bodenwände der Löcher bilden und die Seitenflanken des Kanals freiliegen,
d) Aufbringen einer ersten Metallschicht (132) auf mindestens die Wände der Löcher, die mindestens die Seitenflanken des Kanals bedeckt,
e) Silicidieren bzw. Ausbilden einer Halbleiter/Metall-Legierung der Seitenflanken des Kanals,
f) Aufbringen einer zweiten Metallschicht (134) auf die erste Metallschicht, wobei - mit den im vorhergehenden silicidierten Bereichen - die Source und das Drain des Transistors gebildet werden,
g) mechanisch/chemisches Einebnen der zweiten Metallschicht unter Stoppen an der harten Maske.

2. Verfahren nach Anspruch 1, wobei der den Kanal (102) bildende Halbleitermaterialbereich ein Halbleiteroberflächenschichtbereich des Substrats (108, 110) des Typs SOI ist und die Orte der Source (136) und des Drain (138) Zonen einer dielektrischen Schicht (108) des Substrats (108, 110) sind, die durch Ätzen der Halbleiteroberflächenschicht freigelegt wurden.

3. Verfahren nach einem der vorhergehenden Ansprüche, wobei das Herstellen der zwei Löcher (128) in dem Schritt c) durch Lithographie und Ätzen von Bereichen der zweiten dielektrischen Schicht (122), die sich auf der Höhe der Orte von Source und Drain befinden, und durch ein Entfernen von Bereichen der ersten dielektrischen Schicht (120), die von den verbleibenden Bereichen (126) der zweiten dielektrischen Schicht (122) nicht bedeckt sind, durchgeführt wird.

4. Verfahren nach einem der vorhergehenden Ansprüche, wobei in dem Schritt d) das Aufbringen der ersten Metallschicht (132) in gleicher Weise auf der Struktur und auf dem auf der Höhe der peripheren Zone verbleibenden dielektrischen Bereich ausgeführt wird.

5. Verfahren nach einem der vorhergehenden Ansprüche, das ferner zwischen den Schritten e) und f) einen Schritt des Aufbringens einer Schicht auf der Basis von Titan und/oder Titannitrid und/oder Wolfram auf die erste Metallschicht (132) aufweist.

6. Verfahren nach einem der vorhergehenden Ansprüche, das ferner nach dem Schritt f) einen Schritt des Aufbringens einer Oxidschicht auf die zweite Metallschicht (134) aufweist.

7. Verfahren nach einem der vorhergehenden Ansprüche, wobei die erste Metallschicht (132) eine Schicht auf der Basis von Platin und/oder Nickel und/oder Erbium und/oder Ytterbium und/oder Cobalt und/oder Titan ist.
